# EUROPÄISCHE PATENTSCHRIFT

(11) **EP 1 802 185 B1**
(45) Veröffentlichungstag und Bekanntmachung des Hinweises auf die Patenterteilung: **19.10.2011**
(21) Anmeldenummer: 06026528.7
(22) Anmeldetag: 21.12.2006
(51) Int. Cl.: H05K 3/14

(54) **Verfahren zum Aufbringen von Material auf ein Bauteil**
Method to apply material to a component
Procédé pour l'application de matériau sur un composant

(30) Priorität: 24.12.2005 DE 102005062271
(43) Veröffentlichungstag der Anmeldung: 27.06.2007
(73) Patentinhaber: Leoni AG, 90402 Nürnberg (DE)
(72) Erfinder: Götz, Knuth, 95511 Mistelbach (DE); Süß-Wolf, Robert, 90473 Nürnberg (DE); De Paolis, Marco, 90763 Fürth (DE); Geist, Dieter, 91301 Forchheim (DE)
(74) Vertreter: FDST Patentanwälte

(56) Entgegenhaltungen:
- WO-A-02/068245
- JP-A- 62 013 287
- US-A- 3 042 591
- S. DADBIN: "Surface modification of LDPE film by CO2 pulsed laser irradiation" EUROPEAN POLYMER JOURNAL, [Online] Bd. 38, 12. Juni 2002 (2002-06-12), Seiten 2489-2495, XP002519737 Gefunden im Internet: URL:http://dx.doi.org/10.1016/S0014-3057(0 2)00134-9> [gefunden am 2008-03-17]
- COOPER ET AL: "Surface characterization of pulsed UV-laser modified polyamide films" THIN SOLID FILMS, ELSEVIER-SEQUOIA S.A. LAUSANNE, CH, Bd. 303, Nr. 1-2, 15. Juli 1997 (1997-07-15), Seiten 180-190, XP005256730 ISSN: 0040-6090
- ELKE BREMUS-KOBBERLING AND ARNOLD GILLNER: "Laser structuring and modification of surfaces for chemical and medical micro components", PROCEEDINGS OF THE SPIE, SPIE, BELLINGHAM, VA, US, vol. 5063, 1 January 2003 (2003-01-01), pages 217-222, XP007915812, ISSN: 0277-786x

## Beschreibung

Die Erfindung betrifft ein Verfahren zum Aufbringen von Material auf ein Bauteil nach Anspruch 1. Die Erfindung betrifft weiterhin ein Bauteil mit auf seiner Oberfläche in einem Haftbereich aufgespritztes Material nach Anspruch 16.

Aus der EP 1 363 811 B1 sind ein derartiges Verfahren und ein derartiges Bauteil zu entnehmen. Das Bauteil dient hierbei als ein Kraftfahrzeug-Formbauteil. Das aufgespritzte Material bildet Leiterbahnen aus, die somit integraler Bestandteil des Kraftfahrzeug-Formbauteils sind. Das Material, insbesondere Kupferpartikel, wird hierbei mit einem thermischen Spritzverfahren, insbesondere mit Hilfe des so genannten Flammspritzens aufgebracht. Um eine definierte Leiterbahnstruktur zu ermöglichen, ist hierbei vorgesehen, die Oberfläche des Formbauteils zunächst selektiv entsprechend einem vorgesehenen Verlauf der Leiterbahn zu behandeln, so dass die Oberfläche Bereiche unterschiedlicher Haftung aufweist. Nachfolgend wird in einem zweistufigen Verfahren zunächst eine Keimschicht und auf dieser dann eine Leiterbahn im Haftbereich aufgebracht.

Für eine klare Abgrenzung zwischen zueinander benachbarten Leiterbahnen ist hierbei von Bedeutung, dass die Leiterbahnen durch scharfe Konturen gebildet sind und das aufgespritzte Material nicht über diese Konturen hinweg "verwaschen" sind. Entscheidend hierfür ist, dass beim Aufspritzen des Materials das Material in den nicht haftenden Teilbereichen der Oberfläche zuverlässig nicht haftet bzw. wieder leicht entfernt werden kann, da der beim thermischen Spritzen auf die Bauteiloberfläche auftreffende Teilchenstrahl üblicherweise breiter ist als die auszubildende Leiterbahnstruktur.

Es hat sich jedoch gezeigt, dass auch außerhalb der vorbereiteten Haftbereiche teilweise Partikel auf der Oberfläche ablagern und haften bleiben, so dass neben dem eigentlich vorgesehenen Leiterbahnverlauf sich zusätzliche Nester oder Artefakte ausbilden können. Hier besteht die Gefahr, dass über diese Artefakte ein elektrischer, nicht gewünschter Kontakt zwischen zwei benachbarten Leiterbahnen ausgebildet wird.

Um dies zu vermeiden werden teilweise Masken oder Maskierungsmittel eingesetzt, die allerdings einen erheblichen technischen Aufwand erfordern und damit auch kostenintensiv sind.

Aus der US 3.042,591 ist ein Verfahren zur Erzeugung von Leiterbahnen auf einem Kunststoff-Bauteil zu entnehmen, bei dem die Bahnen mit Hilfe eines Spritzverfahrens in Nuten erzeugt werden, die in die Bauteiloberfläche eingelassen sind. Die Nuten selber sind aufgeraut, um eine gute Haftung für das aufgspritzte Material zu erzielen.

Der Erfindung liegt die Aufgabe zugrunde, das Aufbringen eines Materials auf ein Bauteil insbesondere mit einem thermischen Spritzverfahren zu ermöglichen, bei dem zuverlässig scharfkantige Strukturen des aufgespritzten Materials ausgebildet werden.

Die Aufgabe wird gemäß der Erfindung gelöst durch ein Verfahren zum Aufbringen von Material auf ein Bauteil gemäß Patentanspruch 1. Danach ist vorgesehen, dass vor dem Aufspritzen des Materials auf die Oberfläche des Bauteils diese durch eine kontrollierte Oberflächenbehandlung in einen Haftbereich und in einen nicht haftenden Bereich unterteilt wird, wobei in dem nicht haftenden Bereich eine noppenartige Oberflächenstruktur ausgebildet wird.

Untersuchungen haben nämlich gezeigt, dass durch die noppenartige Oberflächenstruktur ein zuverlässiges Nichthaften des Materials in diesem Bereich erreicht ist. Unter noppenartiger Oberflächenstruktur wird hierbei eine Struktur verstanden, die in etwa punktförmige Erhebungen als einzelne Noppen aufweist. Diese Noppen sind hierbei insbesondere nach Art von Halbkugeln ausgebildet, bilden daher eine kugelartig gekrümmte Oberfläche aus. Eine derartig strukturierte Oberfläche zeigt eine äußerst geringe Haftung und eine äußerst geringe Benetzbarkeit für das aufgespritzte Material. Es wird dabei davon ausgegangen, dass dieser Effekt vergleichbar mit dem Lotus-Effekt ist, dass also durch diese gezielte Strukturierung der Oberfläche eine äußerst geringe Benetzbarkeit erreicht ist bzw. dass die auftreffenden einzelnen Partikel auf der Oberfläche zu dieser nur einen sehr großen Kontaktwinkel ausbilden. Aufgrund dieser geringen Haftbarkeit sind ungewollte Ablagerungen auf der Oberfläche, also Artefakte oder Nester, vermieden. Dadurch lassen sich durch den anschließenden Spritzvorgang Strukturen, insbesondere Leiterbahnstrukturen, mit klar abgegrenzten Randbereichen ausbilden.

Die noppenartige Oberflächenstruktur wird hierbei vorzugsweise mittels einer Laserbehandlung erzeugt. Durch die Verwendung eines Lasers ist eine scharfe Abgrenzung zwischen dem Haftbereich und dem nicht haftenden Bereich problemlos möglich.

Um die noppenartige Struktur auszubilden wird weiterhin vorzugsweise ein gepulster Laser eingesetzt. Durch das Auftreffen der einzelnen Laserpulse mit hoher Energie auf der Oberfläche wird beim Auftreffen des jeweiligen Laserpulses ein jeweiliger Noppen erzeugt. Durch die hohe Energiedichte des Laserpulses erfolgt lokal ein sehr hoher Wärmeeintrag und es bilden sich insbesondere bei der Verwendung eines Kunststoff-Bauteils nach Art von Bläschen ausgebildete Noppen aus.

Gemäß einer zweckdienlichen Weiterbildung wird die Oberflächenstruktur hierbei derart ausgebildet, dass an den Noppen unbehandelte Oberflächenbereiche angrenzen. Untersuchungen haben nämlich gezeigt, dass durch diese Maßnahme der Effekt der geringen Haftung positiv beeinflusst wird. Die Noppen sind daher zumindest in einer Ausbreitungsrichtung der Oberfläche einzelweise angeordnet, d.h. sie weisen einen insbesondere definierten Abstand zueinander auf.

Zweckdienlicherweise beträgt der Anteil der unbehandelten Oberflächenbereiche etwa 20% bis 60% und insbesondere etwa 40% der Gesamtoberfläche des nicht haftenden Bereichs.

Bevorzugt bilden die Noppen ein gleichmäßiges Muster aus, sind also nicht chaotisch oder wahllos über die Oberfläche verteilt. Vielmehr bilden sie wiederkehrende Strukturen und Symmetrien aus sie sind z.B. in definierten Abständen zueinander angeordnet, wobei die Abstände in verschiedenen Richtungen unterschiedlich sein können. In einer bevorzugten Variante ist beispielsweise vorgesehen, dass die Noppen in einer ersten Richtung jeweils unmittelbar aneinander angrenzen, so dass sie sich berühren und einzelne Reihen bilden, wobei die einzelnen Noppenreihen voneinander um beispielsweise einen Noppendurchmesser oder bis zu 50 µm beabstandet sind. Gemäß einer bevorzugten zweiten Ausgestaltung sind demgegenüber die Noppen gitterartig angeordnet, d.h. die einzelnen Noppen sind jeweils allseitig von einem unbehandelten Oberflächenbereich umgeben und die einzelnen Noppen bilden die Gitterpunkte eines Gitters. Die Noppen weisen hierbei insbesondere gleichmäßige Abstände zu den benachbarten Noppen von etwa 10 µm - 90 µm auf.

Weiterhin haben die Noppen vorzugsweise einen Durchmesser von bis etwa 90 µm. Zweckdienlicherweise beträgt gleichzeitig die Höhe der Noppen bis etwa 30 µm und liegt insbesondere im Bereich von etwa 5 µm.

Um im Haftbereich eine besonders gute Haftung zu erzielen, ist vorzugsweise vorgesehen, dass auch der Haftbereich oberflächenbehandelt wird. Im Unterschied zu dem Oberflächenbereich des nicht haftenden Bereichs ist hierbei gemäß einer zweckdienlichen Ausgestaltung vorgesehen, dass im Haftbereich die Oberfläche vollflächig behandelt wird. Es hat sich gezeigt, dass sich eine vollflächige Behandlung für die Haftung positiv auswirkt. Insbesondere wird durch die Oberflächenbehandlung des Haftbereichs die Oberflächenrauigkeit gegenüber dem Ursprungszustand erhöht, um somit eine bessere Adhäsion der aufgespritzten Partikel auf der Oberfläche zu gewährleisten.

Um dies zu erreichen ist in einer bevorzugten Ausgestaltung vorgesehen, dass im Haftbereich Furchen ausgebildet werden, also langgestreckte, linienförmige Vertiefungen, zwischen denen sich Erhebungen ausbilden. Die Tiefe dieser Furchen liegt hierbei vorzugsweise im Bereich der Höhe der Noppen. Die Furchen sind hierbei dadurch ausgebildet, dass - im Vergleich zu der Ausbildung der noppenartigen Struktur - der Laser kontinuierlich die Oberfläche bestrahlt und insbesondere auch ein höherer Energieeintrag als bei der Ausbildung der noppenartigen Oberflächenstruktur erfolgt.

In einer vorteilhaften Ausgestaltung des Verfahrens wird die Oberflächenbehandlung dabei derart gesteuert ausgeführt, dass in nur einem Arbeitsschritt sowohl der Haftbereich als auch der nicht haftende Bereich ausgebildet werden. D.h. bei der Verwendung eines Lasers wird dieser sukzessive beispielsweise linienweise über das Bauteil geführt. Der Laser wir hierbei beim Überfahren des auszubildenden Haftbereichs und des auszubildenden nicht haftenden Bereichs unterschiedlich angesteuert. Durch diese Maßnahme besteht daher die Möglichkeit, allein durch die Ansteuerung des Lasers auch komplexe Bahn- oder Leiterbahnstrukturen zu erzeugen.

Vorzugsweise wird zugleich mit der Oberflächenbehandlung auch die Oberfläche von Verunreinigungen gereinigt. Durch diese Maßnahme ist daher kein nachfolgender Bearbeitungsschritt mehr erforderlich, um beispielsweise ölhaltige Ablagerungen auf der Oberfläche oder sonstige Verunreinigungen zu entfernen, die die nachfolgende Haftung der Spritzpartikel negativ beeinflussen würden.

Als Oberflächenmaterial des Bauteils wird insbesondere ein Thermoplast, bevorzugt ein Polyamid oder ein Polypropylen verwendet. Bei Thermoplasten, insbesondere bei Polyamid oder Polypropylen, ist die Ausbildung einer noppenartigen Struktur mit der Laserbehandlung problemlos möglich. Zum anderen zeigen diese Materialien insbesondere in Verbindung mit einem ausgewählten insbesondere metallischen Spritzmaterial, vorzugsweise Kupfer, ein besonders gutes Zusammenspiel dahingehend, dass das aufgespritzte Material in den nicht haftenden Bereichen auf der Oberfläche nicht haften bleibt.

Die Aufgabe wird erfindungsgemäß weiterhin gelöst durch ein Bauteil mit den Merkmalen des Anspruchs 16. Die im Hinblick auf das Verfahren angeführten Vorteile und bevorzugten Ausgestaltungen sind sinngemäß auch auch das Bauteil zu übertragen.

Ausführungsbeispiele der Erfindung werden im Folgenden anhand der Figuren näher erläutert. Es zeigen jeweils in schematischen, teilsweise stark vereinfachten Darstellungen:
- Fig. 1: eine Darstellung des Verfahrens zum Aufbringen von Material auf ein Bauteil mit Hilfe eines thermischen Spritzverfahrens,
- Fig. 2: eine Aufsicht auf ein Bauteil mit bahnartigen Strukturen,
- Fig. 3: eine mikroskopisch vergrößerte Darstellung eines nicht haftenden Oberflächenbereichs mit einer noppenartigen Oberflächenstruktur sowie
- Fig. 4: eine mikroskopisch vergrößerte Darstellung einer Oberfläche mit einem nicht haftenden Bereich mit einer noppenartigen Oberflächenstruktur sowie einem an diesen Bereich angrenzenden Haftbereich.

Gemäß der stark vereinfachten und schematisierten Darstellung des Auftragsverfahrens gemäß Anspruch 1 wird auf ein Bauteil 2 Material 4, insbesondere Kupfer oder eine Kupferlegierung, mit Hilfe eines thermischen Spritzverfahrens aufgespritzt. Als Spritzverfahren wird hier das thermische Spritzen verstanden, wie es in der DIN EN657 beschrieben und definiert ist. Insbesondere wird für das Aufspritzen des Materials 4 das so genannte Flammspritzen herangezogen. Hierbei wird das als Einzelpartikel aufbereitete Material 4 gemeinsam mit einem Trägergas mit Hilfe einer Flammspritzdüse 6 auf die Oberfläche 8 des Bauteils 2 aufgespritzt. Die Partikel bilden zusammen mit dem Trägergas, welches üblicherweise ein Inertgas ist, einen Strahlkegel 10 aus. Dessen Durchmesser bzw. Breite ist hierbei in der Regel größer als die auf der Oberfläche 8 auszubildende Struktur.

Um hier diskrete und scharf abgegrenzte Strukturen, insbesondere Leiterbahnstrukturen sicher zu erzeugen wird die Oberfläche 8 geeignet vorbehandelt, so dass sich selektiv, entsprechend dem gewünschten Verlauf der aufzubringenden Strukturen Bereiche unterschiedlicher Haftung ausbilden.

Bei dem hier beschriebenen Verfahren wird die gesamte Oberfläche 8 mit Hilfe eines Lasers behandelt. Wobei hierbei die Bereiche unterschiedlicher Haftung durch eine unterschiedliche Laserbehandlung ausgebildet werden. Diese unterschiedliche Laserbehandlung erfolgt durch die Wahl von unterschiedlichen Betriebsparametern, wie beispielsweise Verfahrgeschwindigkeit des Lasers, Energiedichte des Lasers, Geometrie des Brennflecks des Lasers, etc.

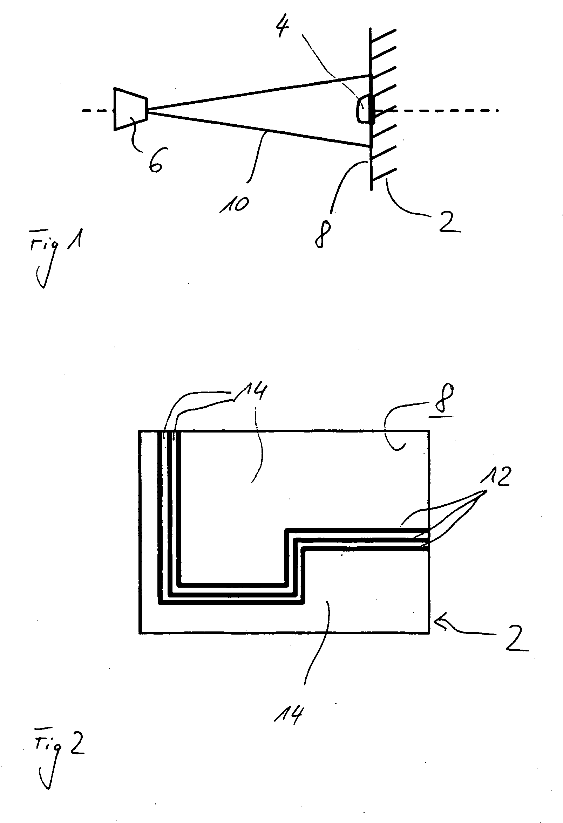

Mit einer derartigen kontrollierten Laserbehandlung lassen sich daher problemlos und in nur einem Verfahrensschritt auf der Oberfläche 8 Haftbereiche 12 und nicht haftende Bereiche 14 ausbilden und scharf gegeneinander abgrenzen. Dies ist in Fig. 2 schematisch illustriert, wobei hier die einzelnen Haftbereiche 12 bahnartig ausgebildet sind. Bei dem nachfolgenden Spritzen werden auf diesen Haftbereichen 12 die Partikel abgeschieden und bauen somit eine leitfähige Schicht auf, die zu den benachbarten leitfähigen Schichten abgegrenzt ist. Somit werden elektrisch leitfähige Leiterbahnen ausgebildet, die unmittelbar auf das Bauteil 2 aufgebracht und Teil desselben sind.

Das Bauteil 2 ist beispielsweise ein Formbauteil für ein Kraftfahrzeug, beispielsweise ein Türmodul, ein Armaturenbrett, ein Dachhimmel, etc. Prinzipiell ist die Anwendung des hier beschriebenen Verfahrens jedoch nicht nur auf Bauteile für den Kraftfahrzeugbereich und nicht nur für die Erzeugung von Leiterbahnstrukturen geeignet. Das Verfahren dient ganz allgemein zur Erzeugung von diskreten, scharf abgegrenzten aufgespritzten Strukturen. Als Spritzmaterial wird hierbei insbesondere metallisches Material, insbesondere Kupfer oder eine Kupferlegierung, herangezogen. Das Bauteil 2 besteht insbesondere aus einem thermoplastischen Material, bevorzugt aus Polyamid oder Polypropylen. Zumindest die Oberfläche 8 des Bauteils 2 besteht aus diesem Material.

Durch die Ausbildung insbesondere der nicht haftenden Bereiche 14 ist die Verwendung von Masken oder anderweitigen Maskierungsmittein nicht erforderlich und bevorzugt auch nicht vorgesehen.

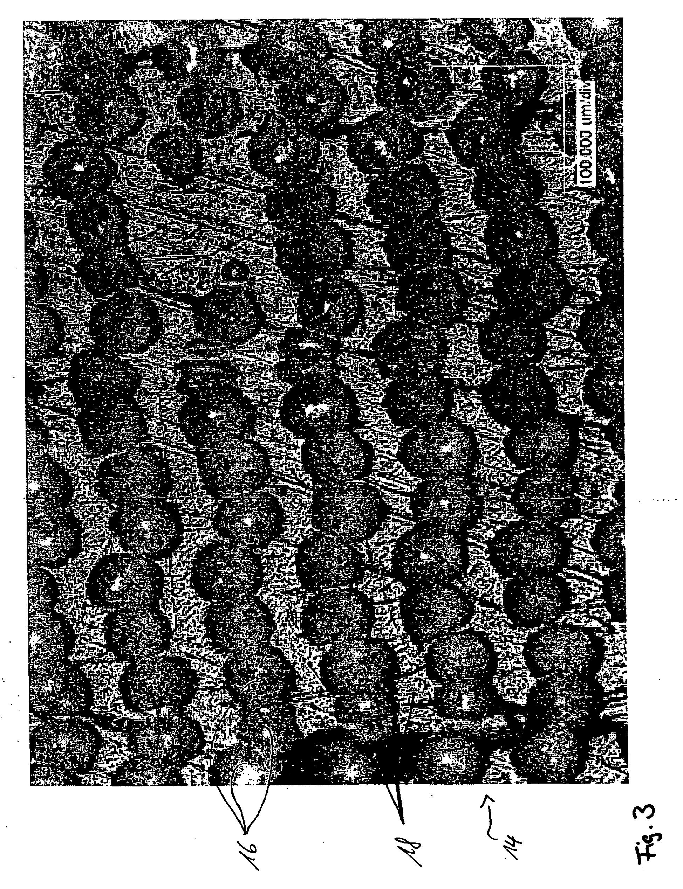

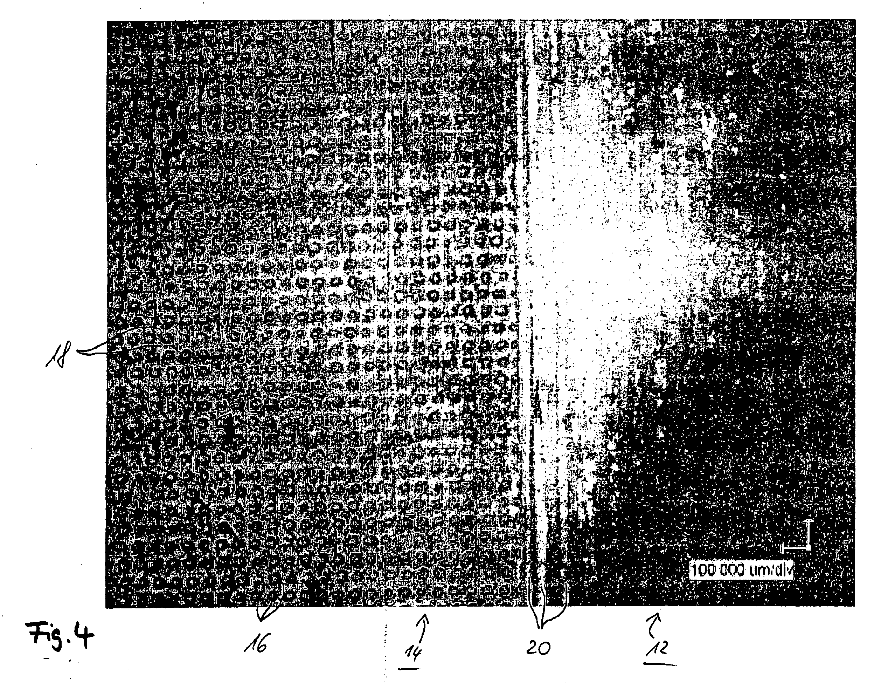

Für das Erzeugen der nicht haftenden Bereiche 14 wird die Oberfläche 8 in diesen Bereichen mittels eines gepulsten Lasers behandelt, so dass sich insgesamt eine noppenartige Oberflächenstruktur ergibt. Diese noppenartige Oberflächenstruktur ist aus der Fig. 3 sowie aus Fig. 4, linke Bildhälfte zu entnehmen, wobei die beiden Mikroskopaufnahmen mit unterschiedlichen Vergrößerungen ausgeführt wurden. Durch die gepulste Laserbehandlung entstehen einzelne diskrete Noppen 16, also nach Art von Halbkugeln ausgebildete Erhebungen auf der Oberfläche 8. Durch die gepulste Laserbehandlung mit dem hohen Energieeintrag wird das Oberflächenmaterial punktförmig und kurzfristig stark erwärmt, so dass sich lokal die einzelnen Noppen 16 nach Art von Bläschen ausbilden. Die Parameter für die Laserbehandlung sind dabei derart eingestellt, dass die Noppen etwa einen Durchmesser von 10 µm bis 90 µm aufweisen. Die Höhe der Noppen liegt zwischen etwa 5 µm und 30 µm

Im Ausführungsbeispiel der Fig. 3 reihen sich die einzelnen Noppen 16 in Längsrichtung unmittelbar aneinander an, berühren sich also. Demgegenüber ist im Ausführungsbeispiel der Fig. 4 eine gitterartige Noppenstruktur ausgebildet, bei der die Noppen jeweils einzelweise angeordnet sind. Die aneinander angrenzenden Noppen 16 gemäß Fig. 3 bilden daher Noppenreihen, die nicht zwangsläufig streng geradeaus verlaufen müssen, sondern auch schlangenlinienförmig oder gebogen verlaufen können. Beide Oberflächenstrukturen weisen eine gleichmäßige symmetrische Verteilung der einzelnen Noppen 16 auf. Im Fall der Fig.3 ist beispielsweise der Abstand zwischen zwei benachbarten Noppenreihen jeweils gleich. Es ist daher zwischen den einzelnen Noppenreihen ein gleiches Rastermaß vorgesehen. Umgekehrt ist auch bei dem Ausführungsbeispiel nach Fig. 4 ein konstantes Rastermaß sowohl in Längsrichtung als auch in Querrichtung ausgebildet.

Von besonderer Bedeutung ist in beiden Fällen, dass zwischen den einzelnen Noppen 16 unbehandelte Oberflächenbereiche 18 bestehen, also Bereiche, die von der Laserbehandlung nicht beeinflusst sind. Diese unbehandelten Oberflächenbereiche 18 sind die Bereiche zwischen den einzelnen Noppen 16. Der Anteil des unbehandelten Oberflächenbereichs 18 beträgt insbesondere etwa 40% der Gesamtoberfläche im nicht haftenden Bereich 14. D.h. die Noppen 16 überdecken etwa 60% des Oberflächenbereichs 18. Bei der Ausführungsvariante der Fig. 4 mit der gitterartigen Anordnung kehrt sich dieses Verhältnis in etwa um, und die Noppen 16 überdecken etwa 40% des Oberflächenbereichs 18.

Wie aus Fig. 4 zu entnehmen ist, schließt sich an den nicht haftenden Bereich 14 scharf abgegrenzt der Haftbereich 12 an. Dieser ist bevorzugt ebenfalls laserbehandelt. Im Unterschied zu dem nicht haftenden Bereich 14 ist er jedoch vollflächig behandelt, so dass also die gesamte Oberfläche durch die Laserbehandlung verändert ist. Im Ausführungsbeispiel weist der Haftbereich 12 linienartige, kontinuierlich durchgezogene Strukturen nach Art von Gräben oder Furchen 20 auf, zwischen denen sich Erhebungen 22 nach Art von Wellen befinden. Durch diese Maßnahme ist im Haftbereich 12 eine definierte Oberflächenrauigkeit ausgebildet und unterstützt die Haftung des Materials 4 auf den Haftbereich 12. Die einzelnen Furchen 20 sind hierbei - ähnlich wie die einzelnen Noppenreihen - im Mikrometerbereich voneinander beabstandet und weisen einen Abstand bis zu etwa 50 µm zueinander auf. Die Höhendifferenz zwischen dem tiefsten Punkt der Furchen 20 und dem höchsten Punkt der Erhebung 22 liegt ebenfalls im Bereich von etwa 10 µm bis 50 µm. Die Breite der Furchen liegt etwa im Bereich bis zu 20 µm.

Insgesamt ist daher sowohl im nicht haftenden Bereich 14 als auch im Haftbereich 12 die Oberfläche 8 mit einer Mikrostruktur versehen, also mit Strukturen, deren charakteristische Größen, wie beispielsweise Abstand zueinander, etc. < 100 µm und insbesondere < 50 µm betragen. Durch diese Mikrostrukturierung, insbesondere durch die noppenartige Mikrostrukturierung im nicht haftenden Bereich 14, ist eine klare und scharfe Abgrenzung des aufgespritzten Materials 4 zu den benachbarten Oberflächenbereichen erreicht.

### Bezugszeichenliste

- 2: Bauteil
- 4: Material
- 6: Flammspritzdüse
- 8: Oberfläche
- 10: Strahlkegel
- 12: Haftbereich
- 14: nicht haftender Bereich
- 16: Noppen
- 18: unbehandelter Oberflächenbereich
- 20: Furche
- 22: Erhebung

## Patentansprüche

1. Verfahren zum Aufbringen von Material (4) auf ein Bauteil (2), bei dem zuerst das Bauteil (2) behandelt wird, so dass ein Haftbereich (12) und ein nicht haftender Bereich (14) für das Material (4) ausgebildet werden, und bei dem nachfolgend das Material (4) durch ein thermisches Spritzverfahren auf den Haftbereich (12) aufgebracht wird,
**dadurch gekennzeichnet,**
**dass** das Behandeln durch eine kontrollierte Oberflächenbehandlung der Oberfläche (8) des Bauteils (2) in dem nicht haftenden Bereich (14) geschieht, so dass eine noppenartige Oberflächenstruktur erzeugt wird.

2. Verfahren nach Anspruch 1,
**dadurch gekennzeichnet,**
**dass** die noppenartige Oberflächenstruktur mittels einer Laserbehandlung erzeugt wird.

3. Verfahren nach Anspruch 2,
**dadurch gekennzeichnet,**
**dass** ein gepulster Laser eingesetzt wird, so dass beim Auftreffen der Laserpulse die einzelnen Noppen (16) der Oberflächenstruktur erzeugt werden.

4. Verfahren nach einem der vorhergehenden Ansprüche,
**dadurch gekennzeichnet,**
**dass** an die Noppen (16) unbehandelte Oberflächenbereiche (18) angrenzen.

5. Verfahren nach Anspruch 4,
**dadurch gekennzeichnet**,
der Anteil des unbehandelten Oberflächenbereichs (18) etwa 20% bis 60% und insbesondere etwa 40% der Gesamtoberfläche des nicht haftenden Bereichs (14) beträgt.

6. Verfahren nach einem der vorhergehenden Ansprüche,
**dadurch gekennzeichnet,**
**dass** die Noppen (16) ein gleichmäßiges Muster bilden.

7. Verfahren nach einem der vorhergehenden Ansprüche,
**dadurch gekennzeichnet,**
**dass** die Noppen (16) einen Durchmesser von ca. 10µm - 90µm aufweisen.

8. Verfahren nach einem der vorhergehenden Ansprüche,
**dadurch gekennzeichnet,**
**dass** die Noppen (16) eine Höhe bis etwa 30µm und insbesondere im Bereich von etwa 5µm aufweisen.

9. Verfahren nach einem der vorhergehenden Ansprüche,
**dadurch gekennzeichnet,**
**dass** im Haftbereich (12) die Oberfläche (8) vollflächig behandelt wird.

10. Verfahren nach einem der vorhergehenden Ansprüche,
**dadurch gekennzeichnet,**
**dass** im Haftbereich (12) Furchen (20) ausgebildet werden.

11. Verfahren nach einem der vorhergehenden Ansprüche,
**dadurch gekennzeichnet,**
**dass** die Oberflächenbehandlung derart gesteuert ausgeführt wird, dass in nur einem Arbeitsschritt sowohl der Haftbereich (12) als auch der nicht haftende Bereich (14) ausgebildet werden.

12. Verfahren nach einem der vorhergehenden Ansprüche,
**dadurch gekennzeichnet,**
**dass** mit der Oberflächenbehandlung die Oberfläche (8) zugleich auch von Verunreinigungen gereinigt wird.

13. Verfahren nach einem der vorhergehenden Ansprüche,
**dadurch gekennzeichnet,**
**dass** durch den Haftbereich (12) eine definierte, abgegrenzte Bahnstruktur gebildet wird.

14. Verfahren nach einem der vorhergehenden Ansprüche,
**dadurch gekennzeichnet,**
**dass** das aufgespritzte Material (4) elektrische Leiterbahnen bildet.

15. Verfahren nach einem der vorhergehenden Ansprüche,
**dadurch gekennzeichnet,**
**dass** als Oberflächenmaterial des Bauteils (2) ein Thermoplast, insbesondere Polyamid oder Polypropylen verwendet wird.

16. Bauteil (2) mit einer Oberfläche (8), auf der ein Haftbereich (12) sowie ein nicht haftender Bereich (14) für ein durch ein thermisches Spritzverfahren aufgebrachtes Material (4) ausgebildet sind und im Haftbereich (12) das Material (4) durch das thermische Spritzverfahren aufgebracht ist,
**dadurch gekennzeichnet,**
**dass** in dem nicht haftenden Bereich (14) die Oberfläche (8) eine noppenartige Oberflächenstruktur aufweist.

17. Bauteil (2) nach Anspruch 16,
**dadurch gekennzeichnet,**
**dass** das aufgespritzte Material (4) eine Leiterbahnstruktur bildet.

## Claims

1. Method for the applying of material (4) onto a component (2) during which the component (2) is treated first so that an adhesion area (12) and a non-adhesive area (14) are formed for the material (4) and during which the material (4) is subsequently applied on the adhesion area (12) by a thermal spraying method
**characterized in**
**that** the treatment is made by a controlled surface treatment of the surface (8) of the component (2) in the non-adhesive area (14) so that a knob-like surface structure is created.

2. Method according to claim 1
**characterized in**
**that** the knob-like surface structure is created by means of a laser treatment.

3. Method according to claim 2
**characterized in**
**that** a pulsed laser is used so that the individual knobs (16) of the surface structure are created when the laser pulses impact.

4. Method according to one of the previous claims
**characterized in**
**that** untreated surface areas (18) are adjacent to the knobs (16).

5. Method according to claim 4
**characterized in**
**that** the share of the untreated surface area (18) comes up to approx. 20 % to 60 % and especially to approx. 40 % of the total surface of the non-adhesive area (14).

6. Method according to one of the previous claims
**characterized in**
**that** the knobs (16) form a uniform pattern.

7. Method according to one of the previous claims
**characterized in**
**that** the knobs (16) have a diameter of approx. 10 µm - 90 µm.

8. Method according to one of the previous claims
**characterized in**
**that** the knobs (16) have a height of approx. up to 30 µm and especially of approx. 5 µm.

9. Method according to one of the previous claims
**characterized in**
**that** the surface (8) is fully treated in the adhesion area (12).

10. Method according to one of the previous claims
**characterized in**
**that** grooves (20) are formed in the adhesion area (12).

11. Method according to one of the previous claims
**characterized in**
**that** the surface treatment is made controlled in a way that both the adhesion area (12) and the non-adhesive area (14) are formed in only one working step.

12. Method according to one of the previous claims
**characterized in**
**that** the surface (8) is cleaned of impurities simultaneously with the surface treatment.

13. Method according to one of the previous claims
**characterized in**
**that** a defined and delimited track structure is formed by the adhesion zone (12).

14. Method according to one of the previous claims
**characterized in**
**that** the sprayed on material (4) forms electric conductor tracks.

15. Method according to one of the previous claims
**characterized in**
**that** a thermoplastic, especially polyamide or polypropylene, is used as surface material of the component (2).

16. Component (2) with a surface (8) on which both an adhesion area (12) and a non-adhesive area (14) for a material (4) applied by a thermal spraying method are formed and in the adhesion area (12) the material (4) is applied by the thermal spraying method
**characterized in**
**that** the surface (8) shows a knob-like surface structure in the non-adhesive area (14).

17. Component (2) according to claim 16
**characterized in**
**that** the sprayed on material (4) forms a conductor track structure.

## Revendications

1. Méthode pour appliquer du matériel (4) sur un élément de construction (2) pendant laquelle d'abord l'élément de construction (2) est traité, de sorte qu'une zone adhésive (12) et une zone non-adhésive (14) sont formées pour le matériel (4), et pendant laquelle le matériel (4) est subséquemment appliqué sur la zone adhésive (12) par une projection thermique,
**caractérisée par le fait**
**que** le traitement se produit par un traitement superficiel contrôlé de la surface (8) de l'élément de construction (2) dans la zone non-adhésive (14), de sorte qu'une structure superficielle ayant l'air de noppes est produite.

2. Méthode selon exigence 1,
**caractérisée par le fait**
**que** la structure superficielle ayant l'air de noppes est produite par un traitement par laser.

3. Méthode selon exigence 2,
**caractérisée par le fait**
**qu'**un laser pulsé est utilisé, de sorte que les noppes particulières (16) de la structure superficielle sont produites au moment de l'impact des impulsions du laser.

4. Méthode selon une des exigences précédentes,
**caractérisée par le fait**
**que** des zones superficielles non-traitées (18) avoisinent les noppes (16).

5. Méthode selon exigence 4,
**caractérisée par le fait**
**que** la part de la zone superficielle non-traitée (18) s'elève à environ 20% jusqu'à 60% et en particulier à environ 40% de la surface totale de la zone non-adhésive (14).

6. Méthode selon une des exigences précédentes
**caractérisée par le fait**
**que** les noppes (16) forment un dessin uniforme.

7. Méthode selon une des exigences précédentes
**caractérisée par le fait**
**que** les noppes ont un diamètre d'environ 10 µm à 90 µm.

8. Méthode selon une des exigences précédentes
**caractérisée par le fait**
**que** les noppes (16) ont jusqu'à environ 30 µm de haut et en particulier elles ont environ 5 µm de haut.

9. Méthode selon une des exigences précédentes
**caractérisée par le fait**
**que** la surface (8) est complètement traitée dans la zone adhésive (12).

10. Méthode selon une des exigences précédentes
**caractérisée par le fait**
**que** des rainures (20) sont formées dans la zone adhésive (12).

11. Méthode selon une des exigences précédentes
**caractérisée par le fait**
**que** le traitement superficiel est réalisé tellement contrôlé que non seulement la zone adhésive (12) mais aussi la zone non-adhésive (14) sont formées dans une seule étape de travail.

12. Méthode selon une des exigences précédentes
**caractérisée par le fait**
**que** la surface (8) est en même temps aussi purifiée de impuretés par le traitement superficiel.

13. Méthode selon une des exigences précédentes
**caractérisée par le fait**
**qu'**une structure de parcours définie et délimitée est formée par la zone adhésive (12).

14. Méthode selon une des exigences précédentes
**caractérisée par le fait**
**que** le matériel appliqué par pistolage (4) forme des parcours conductrices électriques.

15. Méthode selon une des exigencies précédentes
**caractérisée par le fait**
**qu'**une matière thermoplastique, en particulier polyamide ou polypropylene, est utilisée comme matériel superficiel de l'élément de construction (2).

16. Elément de construction (2) avec une surface (8), sur laquelle une zone adhésive (12) ainsi qu'une zone non-adhésive(14) sont formées pour un matériel (4) appliqué par un moulage par injection thermique et sur laquelle le matériel (4) est appliqué dans la zone adhésive (12) par la projection thermique
**caractérisé par le fait**
**que** la surface (8) montre dans la zone non-adhésive (14) une structure superficielle ayant l'air de noppes.

17. Elément de construction (2) selon exigence 16
**caractérisé par le fait**
**que** le matériel appliqué par pistolage forme une structure d'un parcours conductrice.
